**Europäisches Patentamt**

**European Patent Office**

**Office européen des brevets**

(19)

(11) Numéro de publication : **0 555 141 A1**

## (12) DEMANDE DE BREVET EUROPEEN

(21) Numéro de dépôt : **93400258.5**

(22) Date de dépôt : **02.02.93**

(51) Int. Cl.⁵ : **G01R 21/133**

(30) Priorité : **04.02.92 FR 9201218**

(43) Date de publication de la demande :
**11.08.93 Bulletin 93/32**

(84) Etats contractants désignés :
**BE CH DE ES GB IE IT LI NL PT**

(71) Demandeur : **SOCIETE D'APPLICATIONS GENERALES D'ELECTRICITE ET DE MECANIQUE SAGEM**
**6, Avenue d'Iéna**
**F-75783 Paris Cédex 16 (FR)**

(72) Inventeur : **Pradel, Denis**
**2 Rue d'Epluches**
**F-95480 Pierrelaye (FR)**

(74) Mandataire : **Fort, Jacques et al**
**CABINET PLASSERAUD 84, rue d'Amsterdam**
**F-75009 Paris (FR)**

(54) Compteur électronique de consommation d'énergie électrique.

(57) Le compteur permet de mesurer l'énergie électrique alternative consommée dans une charge. Il comprend des moyens pour fournir deux tensions de mesure proportionnelles, la première à la tension appliquée à la charge, l'autre à l'intensité du courant qui traverse la charge et un circuit fournissant un signal de tension représentatif du produit algébrique desdites tensions de mesure. Ce circuit comprend un convertisseur analogique-numérique (14) de conversion de la tension (Ur) de mesure de la tension appliquée en un signal numérique, un multiplieur mixte numérique-analogique (18,20) recevant le signal numérique et la tension (Ui) représentative de l'intensité et fournissant une tension de sortie (Up) proportionnelle à leur produit algébrique, et un convertisseur tension-fréquence (24) fournissant des impulsions de sortie représentant chacune un quantum déterminé d'énergie électrique consommée.

FIG.1.

L'invention concerne les compteurs électroniques utilisables pour déterminer l'énergie électrique consommée dans une charge à laquelle est appliquée une tension alternative ou plus généralement une tension dont le signe s'inverse périodiquement.

On connait déjà un compteur électronique du type comprenant des moyens pour fournir deux tensions de mesure proportionnelles, la première à la tension appliquée à la charge, l'autre à l'intensité du courant qui traverse la charge et un circuit fournissant un signal de tension représentatif du produit algébrique desdites tensions de mesure (document FR-A-2 563 013).

Ce compteur connu comprend deux échantillonneurs-bloqueurs attaquant alternativement un convertisseur analogique-numérique par l'intermédiaire d'un amplificateur. La sortie du convertisseur fournit alternativement une information de tension appliquée et une information de courant à un microprocesseur de multiplication et d'intégration. Un tel compteur a une constitution relativement complexe. Il est difficilement réalisable sous forme d'une puce de circuit intégré unique.

La présente invention vise à fournir un compteur électronique du type ci-dessus défini ayant une constitution simple, pouvant être aisément réalisé sous forme d'un circuit intégré à application spécifique (ASIC) et pouvant, au moins dans un mode particulier de réalisation, garantir une précision élevée du fait d'un fonctionnement symétrique qui réduit les erreurs dues au décalage de zéro des amplificateurs.

Dans ce but, l'invention propose notamment un compteur du type ci-dessus défini caractérisé en ce que ledit circuit comprend un convertisseur analogique-numérique de conversion de la tension de mesure de la tension appliquée en un signal numérique, un multiplieur mixte numérique-analogique recevant le signal numérique et recevant la tension de mesure représentative de l'intensité et fournissant une tension de sortie analogique proportionnelle à leur produit algébrique, et un convertisseur tension-fréquence fournissant des impulsions de sortie représentant chacune un quantum déterminé d'énergie électrique consommée.

Le multiplieur mixte a avantageusement une constitution équivalente, du point de vue fonctionnel, à un potentiomètre à commande numérique associé à un amplificateur. Pour réduire l'effet des décalages parasites provoqués par exemple par le décalage de zéro de l'amplificateur et par les tensions de thermocouple résiduelles des résistances qui sont généralement incorporées dans des moyens fournissant les tensions de mesure, le circuit fournissant le signal de tension représentatif du produit des tensions de mesure est avantageusement constitué de façon à être fonctionnellement équivalent à un potentiomètre à deux curseurs associé à un amplificateur différentiel, les curseurs étant gérés de manière que :
- leur position relative puisse être inversée afin qu'elle indique le signe de la fonction de transfert entre le signal analogique constitué par la tension de mesure représentative de l'intensité du courant dans la charge et le signal de tension de sortie,
- le coefficient multiplicateur de ladite tension de mesure ait un module proportionnel à l'amplitude du signal numérique représentatif de la tension appliquée à la charge.

Dans une réalisation simplifiée, le circuit du multiplieur est assimilable à un potentiomètre à deux curseurs dont l'un ou l'autre est mis à la masse.

Enfin, dans une solution particulièrement simple mais qui en contrepartie ne permet pas d'atteindre la même précision que les précédentes pour les multiplications lorsque la tension appliquée à la charge est proche de zéro, (donc deux fois par cycle du courant alternatif), le circuit multiplieur est constitué de façon assimilable à un potentiomètre ayant un curseur unique à commande numérique attaquant un amplificateur, les bornes du potentiomètre recevant l'une la tension de mesure représentative de l'intensité, l'autre une tension de même module mais de signe opposé.

Le convertisseur analogique-numérique peut être remis à jour par une horloge dont la fréquence est supérieure à la fréquence de la tension d'alimentation d'au moins une puissance de dix, ou fonctionner en poursuite.

Le compteur peut comporter une correction automatique de tension de décalage des circuits du multiplieur mixte et du convertisseur tension-fréquence, par échantillonnage-blocage lors des passages par zéro de la valeur numérique représentant la tension appliquée à la charge ; il peut également comporter une correction automatique de tension de décalage de la chaîne de conversion analogique-numérique de la tension appliquée à la charge, par surveillance de la valeur moyenne de la somme des échantillons numériques sur une durée égale à une ou plusieurs périodes de la tension alternative présente aux bornes de la charge.

L'invention sera mieux comprise à la lecture de la description qui suit de modes particuliers de réalisation donnés à titre d'exemples non limitatifs. La description se réfère aux dessins qui l'accompagnent, dans lesquels :
- la figure 1 est un synoptique général d'un compteur suivant un mode particulier de réalisation de l'invention ;
- les figures 2, 3 et 4 montrent trois constitutions possibles du circuit multiplieur de la figure 1.

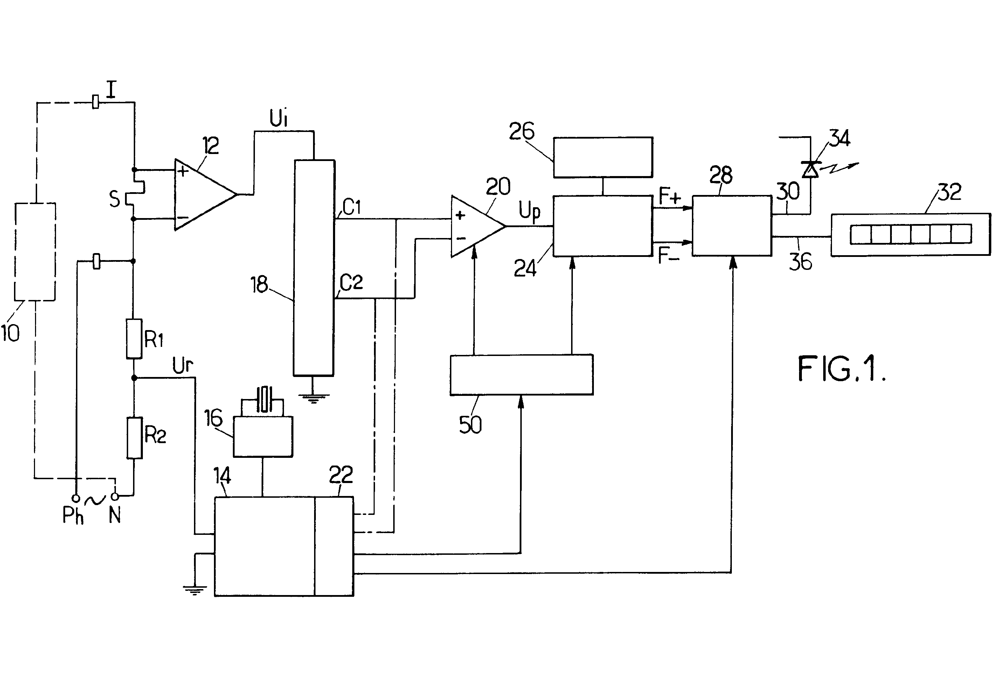

Le compteur montré schématiquement en figure 1 comporte des moyens de génération de tensions ana-

2

EP 0 555 141 A1

logiques de mesure Ur, Ui respectivement proportionnelles à la tension aux bornes de la charge 10 dont la consommation est à mesurer et au courant I dans cette charge. Le schéma de la figure 1 correspond à une alimentation de la charge en courant alternatif monophasé à partir d'une borne de neutre N et d'une borne de phase Ph. Mais le compteur peut être adapté à une alimentation polyphasée par simple duplication de ses composants avant regroupement pour affichage unique.

Les moyens de génération des tensions de mesure montrés en figure 1 ont une constitution classique. Les moyens de génération de Ui comportent une résistance série S parcourue par le courant qui traverse la charge 10 et un pré-amplificateur différentiel 12 dont les entrées sont reliées aux bornes de la résistance S, dont la sortie constitue Ui. Le pré-amplificateur réduit les erreurs de mode commun.

Les moyens de génération de la tension- Ur comportent un pont diviseur R1-R2 dont le point milieu fournit Ur. Les résistances R1 et R2 sont choisies de façon que Ur soit compatible avec les tensions de fonctionnement des circuits intégrés.

La tension Ur est appliquée à un convertisseur analogique-numérique 14. Dans le mode de réalisation montré en figure 1, la cadence de remise à jour du convertisseur est fixée par une horloge 16 dont la fréquence est supérieure à la fréquence de la tension d'alimentation d'au moins une (et de préférence d'au moins deux) puissances de dix de façon que la sommation de quanta d'énergie-correspondant aux intervalles de temps entre remises à jour n'introduise pas d'erreurs significatives par rapport à l'intégration rigoureuse en fonction du temps.

Dans un autre mode de réalisation, qui donne une précision maximale, le convertisseur 14 fonctionne en poursuite, c'est-à-dire que sa sortie change dès que la modification de la tension d'entrée dépasse l'intervalle de quantification. En contrepartie, cette solution exige une vitesse maximale de conversion et provoque un asynchronisme relatif des instants de changement de la valeur numérique de sortie, puisque les instants de changement sont déterminés essentiellement par l'évolution de la valeur de Ur, qu'ils soient ou non synchronisés par une horloge à fréquence fixe.

Une autre solution encore consiste à utiliser une horloge système rapide par rapport à la cadence maximale de changement de la valeur numérique de sortie.

Dans tous les cas, une numérisation sur dix bits sera généralement plus que suffisante pour obtenir une précision de mesure de la consommation de l'ordre de 1 %. Le nombre de bits et la fréquence de renouvellement seront choisis en fonction de la précision à obtenir.

La multiplication mixte analogique-numérique fournissant la puissance instantanée pendant les intervalles de temps séparant deux remises à jour du convertisseur analogique-numérique est effectuée dans un multiplieur qui, dans le cas de la figure 1, est fonctionnellement équivalent à un potentiomètre à commande numérique, à deux curseurs, et un amplificateur différentiel. L'utilisation de deux curseurs permet une multiplication algébrique de façon simple.

Sur la figure 1, la référence 18 désigne l'élément fonctionnellement équivalent au potentiomètre à deux curseurs C1 et C2 pouvant se croiser. L'une des bornes du potentiomètre reçoit la tension de mesure Ui tandis que l'autre est à la masse. Les deux curseurs attaquent les entrées d'un amplificateur différentiel 20. Les deux curseurs sont gérés par un bloc logique 22 qui sera davantage décrit plus loin et donne aux curseurs C1 et C2 une position relative qui est une fonction linéaire de la tension Ur. En d'autres termes, le bloc 22 gère les curseurs C1 et C2 de manière que leurs échelonnements de la masse à la tension Ui, correspondent au signe de la fonction de transfert globale entre Ur et Up (tension de sortie de l'amplificateur différentiel 20) et que leurs emplacements soient en proportion de la valeur de la tension Ur.

On peut alors écrire la tension de sortie de l'amplificateur 20 sous la forme :

$$Up = Ui \times sgn(Ur) \times k(Ur), \text{ où :}$$

sgn désigne le signe de Ur, k (Ur) est la valeur absolue de la différence des atténuations $\alpha_{c1}$ et $\alpha_{c2}$ du potentiomètre pour les curseurs C1 et C2 : $k(Ur) = |\alpha_{c1} - \alpha_{c2}|$.

Up représente en conséquence une puissance instantanée. L'énergie consommée est ensuite obtenue par l'intégration continue, sur des intervalles discrets, de la succession de valeurs approchées de Up, du fait que les curseurs ont un déplacement quantifié.

Dans le cas illustré sur la figure 1, l'intégration nécessaire au comptage d'énergie est effectuée dans un convertisseur tension-fréquence qui convertit les valeurs successives de Up en impulsions représentant chacune un quantum d'énergie sur des sorties F+ et F-, suivant que l'énergie est positive ou négative, c'est-à-dire suivant le signe de Up. Le convertisseur 24 peut avoir une constitution classique et comporter notamment un intégrateur analogique d'entrée, associé à un générateur de facteur d'échelle 26 déterminant le coefficient de proportionnalité entre Up et la fréquence de sortie F.

En conséquence, sur un intervalle de temps déterminé T, on a la relation suivante :

$$\sum_{t}^{t+\Delta t} \left[ \int_{t+n\Delta t}^{t+(n+1)\Delta t} Ui(t)xsgn\ (Ur)xk(Ur)xSt \right] = (F\pm F^{-})\Delta T.\Delta E$$

où :

$\Delta E$ est le quantum interne de numérisation de l'énergie, fixé par le générateur de facteur d'échelle 26.

$\delta t$ est la durée de chaque période de remise à jour des curseurs du potentiomètre 18.

Les autres paramètres ont les significations données plus haut.

Les impulsions de sortie du convertisseur 24 sont accumulées algébriquement dans un bloc 28 d'accumulation, de mise à l'échelle et d'interface. Dans le mode de réalisation illustré sur la figure 1, où l'affichage de sortie comprend un voyant 34 donnant une impulsion lumineuse à chaque incrémentation d'une énergie déterminée (par exemple 1 Wh) et un compteur totalisateur 32, le bloc 28 est prévu pour effectuer une division de fréquence entre la fréquence de sortie des impulsions F+ et F-, afin de fournir sur la sortie 30 des impulsions pour chaque incrémentation à visualiser ; le circuit 28 effectue une autre division de fréquence pour fournir, sur une sortie 36 attaquant le compteur totalisateur 32, une impulsion pour chaque incrément correspondant à un accroissement d'une unité du chiffre le moins significatif sur le compteur totalisareur 32. Lorsque le compteur 32 est de type électromécanique, ce qui constitue la solution la plus économique, le facteur de division du circuit 28 tient compte également de son coefficient de réduction mécanique.

Les moyens d'affichage peuvent être de nature différente de celle montrée en figure 1. Par exemple, l'affichage peut être électronique, sous forme d'un réseau de diodes ou d'un écran plat à cristaux liquides. Dans ce cas, le circuit 28 intègre une mémoire d'accumulation de la consommation et les interfaces nécessaires pour commander l'afficheur électronique.

Le réglage du facteur d'échelle peut être réalisé par divers procédés. Par exemple, il peut être effectué par ajustement de la résistance S. Il peut également être effectué par ajustement au laser d'une résistance commandant en partie la valeur de la tension de référence fournie par le circuit 26. Il est également possible d'utiliser un ajustement par incréments discrets en brûlant un nombre variable de diodes Zener incluses dans le circuit 26, en cas d'intégration de l'ensemble du dispositif (exception faite du compteur-totalisateur 32) sur un circuit intégré.

Le multiplieur mixte fonctionnellement équivalent à un potentiomètre à deux curseurs, peut avoir des constitutions très diverses, dont certaines seront maintenant décrites à titre d'exemple.

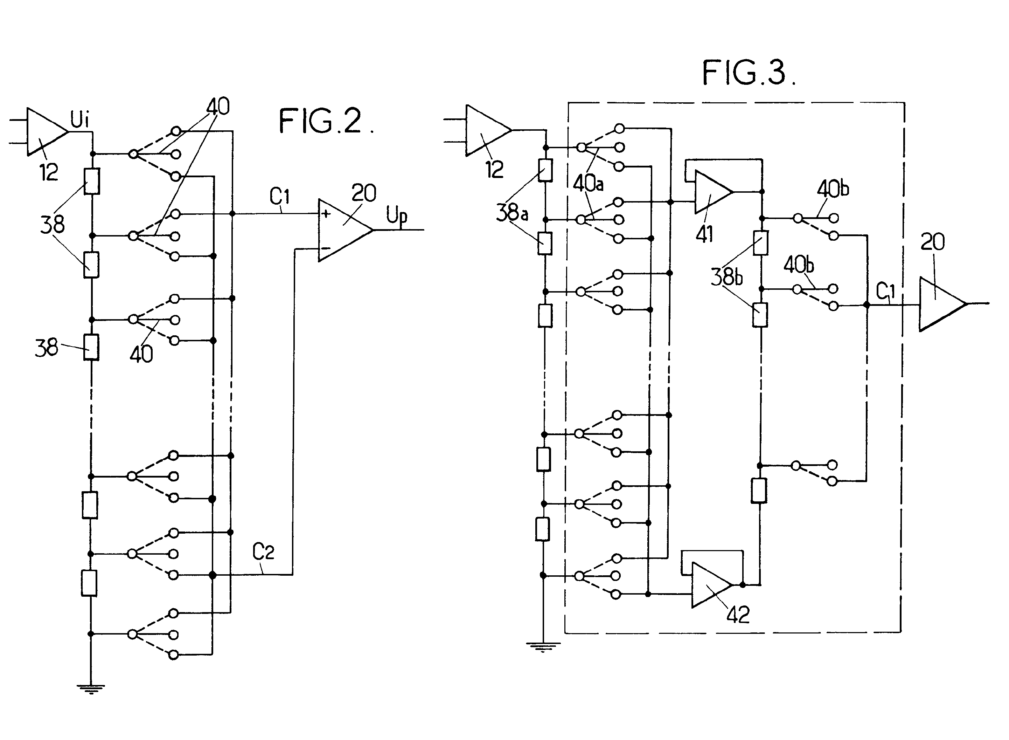

Dans le mode de réalisation montré en figure 2, le multiplieur comprend une chaîne de résistances 38 et autant de commutateurs analogiques 40 qu'il y a de noeuds plus deux, entre les résistances. Chacun des commutateurs peut notamment être constitué par deux transistors MOS, en cas d'intégration sur un circuit intégré. Chaque commutateur 40 permet ainsi d'orienter le noeud vers l'un ou l'autre des curseurs C1 et C2.

Pour réduire les sources d'erreur, la sortie des curseurs C1 et C2 doit être connectée à une impédance qui est élevée par rapport à l'impédance du potentiomètre constitué des résistances 38 et à celle des commutateurs analogiques.

La gestion des curseurs peut être effectuée par le bloc 22 de façon que ces curseurs soient symétriques par rapport au point milieu de la chaîne de résistance ; on rend ainsi le système symétrique.

Dans la variante de réalisation montrée en figure 3, le potentiomètre est du genre Kelvin-Warley c'est-à-dire comporte un potentiomètre de base et un potentiomètre interpolateur placés en série, ce qui permet de réduire le nombre de transistors nécessaires, à résolution donnée. Le premier potentiomètre est constitué par une chaîne de résistance 38a et des commutateurs 40a, permettant chacun d'orienter l'un quelconque des noeuds vers l'un ou l'autre des curseurs d'attaque d'un amplificateur 41 ou 42. Une seconde chaîne de résistances 38b constitue, avec des commutateurs 40b à deux positions seulement, un second potentiomètre qui attaque l'amplificateur 20, qui n'est cette fois pas différentiel.

Les amplificateurs 20 ont un rôle d'isolation. Leur présence n'est pas indispensable si l'impédance du pont diviseur d'interpolation constitué par les résistances 38b est suffisamment grande devant l'impédance des commutateurs 40a et d'une des résistances 38a constitutive du potentiomètre diviseur de base.

La disposition montrée en figure 3 peut être encore subdivisée par adoption d'un réseau d'interpolation en échelle.

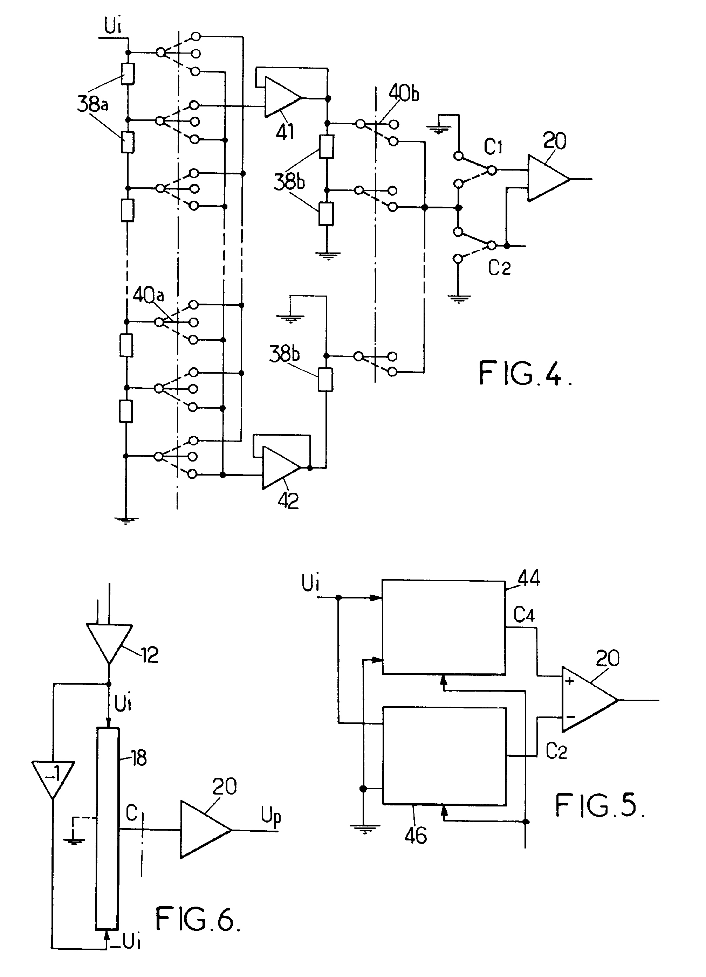

La figure 4 montre une autre variante encore de réalisation du multiplieur mixte. Ces deux variantes se différencient essentiellement de celles de la figure 3 en ce que l'un ou l'autre des curseurs est mis à la masse, c'est-à -dire au potentiel de l'une des bornes du potentiomètre de base, tandis que l'autre curseur est relié à l'un des noeuds du réseau par l'intermédiaire du potentiomètre interpolateur et du potentiomètre de base. C'est le signe de la tension Ur qui détermine lequel des curseurs C1 et C2 est à la masse. Cette fois, l'amlificateur 20 est différentiel, l'une de ses entrées étant mise à la masse.

Dans la variante de réalisation montrée en figure 5, le multiplieur mixte est constitué par un couple de convertisseur multiplieur numérique-analogique 44, 46 qui fournisse chacun une tension correspondant à l'un des curseurs C1 et C2 de la figure 1. Cette solution a l'inconvénient de faire disparaître la corrélation des signaux appliqués qui existent dans le cas de la figure 1. En effet, la symétrie du système se trouve dégradée ; on peut y remédier par une variante n'utilisant qu'un seul convertisseur-multiplieur et en mettant à leur masse l'un ou l'autre des deux curseurs, comme dans le cas de la figure 4.

Une autre variante encore de réalisation, montrée en figure 6, permet d'éviter l'emploi de deux curseurs. Elle comporte un potentiomètre à un seul curseur C commandé par le bloc 22. L'une des bornes reçoit la tension Ui provenant de l'amplificateur 12. L'autre reçoit la tension symétrique -Ui, fournie par un amplificateur inverseur 48 de gain -1. Il n'est plus nécessaire d'utiliser un amplificateur différentiel, puisque le signe de Up est fourni par la position du curseur, d'un côté ou de l'autre du milieu du potentiomètre. Cette solution a l'avantage de la simplicité mais en contrepartie l'inconvénient d'une précision faible lorsque Ur est proche de zéro. Ce défaut peut être atténué en asservissant la position k(Ur)=O à une tension nulle à partir des tensions appliquées aux bornes ou bien en créant une prise médiane reliée à la masse.

Le bloc 22 peut être constitué par un simple réseau logique de synchronisation, cadencé par l'horloge 16. Il peut, en plus de sa fonction de commande, avoir des fonctions de compensation d'offset. Dans le mode de réalisation illustré sur la figure 1, il commande un circuit 50 pour actualiser la mémorisation et la compensation de la tension d'offset de l'amplificateur différentiel 20 et le convertisseur tension-fréquence 24, ce qui confère au compteur une très grande stabilité intrinsèque dans la zone des faibles courants de mesure.

De plus, le bloc 22 peut maintenir automatiquement à zéro le décalage en tension du convertisseur analogique-numérique 14. Lorsque la tension délivrée par le réseau est sensiblement sinusoïdale et à valeur moyenne nulle, ce qui est le cas général, la somme, sur une période, des codes en sortie du CAN, régulièrement répartis dans le temps, doit être nulle. Le résidu représente le décalage opérationnel moyen du CAN 14 qui peut donc être déduit de la sommation de chaque échantillon sur une période de la tension réseau après division par le nombre d'échantillons contenus dans une période.

Le compteur est complété par une alimentation électrique non représentée. Cette alimentation est avantageusement de type capacitif, sans transformateur pour réduire le coût. Une telle alimentation est possible lorsque le compteur est réalisé sous forme d'une pièce de circuit intégré, dont la consommation est faible.

Le compteur est susceptible de nombreuses variantes de réalisation s'ajoutant à celles qui ont été décrites plus haut. Il peut également comporter des circuits supplémentaires de filtrage et de traitement du signal représentatif de l'énergie consommée. En particulier l'amplificateur peut être associé à des circuits analogiques destinés à filtrer les variations rapides de tension provoquées par le bruit dans le système et par le bruit affectant les signaux d'entrée. Ce circuit peut également être prévu pour éliminer des fluctuations autour de la valeur moyenne particulièrement provoquée par une valeur du cosinus $\Phi$ différente de 1. Le convertisseur tension-fréquence peut lui-même être équipé de tels circuits, s'ajoutant ou se substituant à ceux de l'amplificateur 20. Les opérations de filtrage peuvent également ou en plus être effectuées par des moyens numériques.

## Revendications

1. Compteur électronique d'énergie électrique alternative consommée dans une charge, comprenant des moyens pour fournir deux tensions de mesure proportionnelles, la première à la tension appliquée à la charge, l'autre à l'intensité du courant qui traverse la charge et un circuit fournissant un signal de tensions de mesure,

   caractérisé en ce que le circuit comprend un convertisseur analogique-numérique (14) de conversion de la tension non-redressée (Ur) mesurant la tension appliquée en un signal numérique, un multiplieur mixte numérique-analogique (18,20) recevant le signal numérique et la tension (Ui) représentative de l'intensité et fournissant une tension de sortie (Up) proportionnelle à leur produit algébrique, et un convertisseur tension-fréquence (24) fournissant des impulsions de sortie représentant chacune un quantum déterminé d'énergie électrique consommée, ledit multiplieur mixte ayant une constitution équivalente, du point de vue fonctionnel, à un potentiomètre à commande numérique associé à un amplificateur.

2. Compteur selon la revendication 1, caractérisé en ce que le circuit fournissant le signal de tension représentatif du produit des tensions de mesure est un potentiomètre (18) à deux curseurs associé à un amplificateur différentiel (20), les curseurs (C1,C2) étant gérés de manière que :
   - leur position relative puisse être inversée afin qu'elle indique le signe de la fonction de transfert entre la tension de mesure représentative de l'intensité et le signal de tension de sortie,
- le coefficient multiplicateur de la tension de mesure représentative de l'intensité ait un module proportionnel à l'amplitude du signal numérisé de mesure de la tension appliquée à la charge.

3. Compteur selon la revendication 2, caractérisé en ce que les deux curseurs (C1,C2) sont gérés par un bloc logique (22) de façon telle que ces curseurs soient symétriques par rapport au point milieu du potentiomètre.

4. Compteur selon la revendication 1, caractérisé en ce que le circuit multiplieur comprend un potentiomètre (18) à curseur unique à commande numérique attaquant un amplificateur, les bornes du potentiomètre recevant l'une la tension de mesure (Ui) représentative de l'intensité de courant, l'autre une tension de même module mais de signe opposé (-Ui).

5. Compteur selon la revendication 1, caractérisé en ce que le multiplieur mixte comprend un potentiomètre à deux curseurs, l'un ou l'autre des deux curseurs étant mis à la masse et les curseurs attaquant chacun un amplificateur (41,42).

6. Compteur selon l'une quelconque des revendications 1 à 5, caractérisé en ce que le potentiomètre comporte un potentiomètre de base (38a,40a) et un potentiomètre interpolateur (38b,40b) placés en série.

7. Compteur selon l'une quelconque des revendications 1 à 6, caractérisé en ce que le convertisseur analogique-numérique est remis à jour par une horloge (16) dont la fréquence est supérieure à la fréquence de la tension d'alimentation d'au moins une puissance de dix.

8. Compteur selon l'une quelconque des revendications 1 à 6, caractérisé en ce que le convertisseur analogique-numérique fonctionne en poursuite.

9. Compteur selon la revendication 7 ou 8, caractérisé en ce qu'il comprend une correction automatique de tension de décalage des circuits du multiplieur mixte (18,20) et du convertisseur tension fréquence (24) par échantillonnage-blocage lors des passages par zéro de la valeur numérique représentant la tension appliquée à la charge.

10. Compteur selon l'une quelconque des revendications 7 à 9, caractérisé en ce qu'il comprend une correction automatique de tension de décalage de la chaîne de conversion analogique-numérique de la tension appliquée à la charge par surveillance de la valeur moyenne de la somme des échantillons numériques sur une durée égale à une ou plusieurs périodes de la tension alternative présente aux bornes de la charge.

FIG.1.

EP 0 555 141 A1

FIG.3.

20

C1

40b

40b

38b

41

40a

38a

42

12

FIG.2.

Up

20

C1

C2

40

40

38

38

12

Ui

FIG.4.

FIG.5.

FIG.6.

Office européen
des brevets

**RAPPORT DE RECHERCHE EUROPEENNE**

Numero de la demande

EP    93 40 0258

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| X | GB-A-2 221 313 (OMEGA ELECTRIC LIMITED)<br>* abrégé *<br>* page 3, alinéa 3 -alinéa 4;<br>revendications 1,2; figure 1 *<br>--- | 1,8 | G01R21/133 |
| A | US-A-4 839 819 (BEGIN ET AL.)<br>* abrégé *<br>* colonne 5, ligne 61 - colonne 6, ligne 10; figure 5 *<br>--- | 1,9,10 | |
| A | EP-A-0 308 924 (KABUSHIKI KAISHA TOSHIBA)<br>* abrégé; figure 2 *<br><br>----- | 1,7 | |

**DOMAINES TECHNIQUES RECHERCHES (Int. Cl.5)**

G01R

Le présent rapport a été établi pour toutes les revendications

| Lieu de la recherche | Date d'achèvement de la recherche | Examinateur |
|---|---|---|
| LA HAYE | 06 MAI 1993 | KEMPF G.V. |

CATEGORIE DES DOCUMENTS CITES

X : particulièrement pertinent à lui seul
Y : particulièrement pertinent en combinaison avec un
    autre document de la même catégorie
A : arrière-plan technologique
O : divulgation non-écrite
P : document intercalaire

T : théorie ou principe à la base de l'invention
E : document de brevet antérieur, mais publié à la
    date de dépôt ou après cette date
D : cité dans la demande
L : cité pour d'autres raisons

& : membre de la même famille, document correspondant

EPO FORM 1503 03.82 (P0402)